# FASCICULE DE BREVET EUROPEEN

(11) **EP 3 479 015 B1**
(45) Date de publication et mention de la délivrance du brevet: **01.05.2024**
(21) Numéro de dépôt: 17737742.1
(22) Date de dépôt: 29.06.2017
(51) Int. Cl.: F21S 41/14, F21S 41/143, F21S 41/43, F21S 41/663, F21W 102/00, H01L 27/15, F21Y 105/10, F21Y 113/20, H01L 33/08, H01L 33/58

(54) **DISPOSITIF LUMINEUX APTE A GENERER UNE SOURCE A PIXELS FINS**
BELEUCHTUNGSVORRICHTUNG ZUR ERZEUGUNG EINER FEINPIXELQUELLE
LIGHT DEVICE SUITABLE FOR GENERATING A FINE PIXEL SOURCE

(30) Priorité: 01.07.2016 FR 1656341
(43) Date de publication de la demande: 08.05.2019
(73) Titulaire: Valeo Vision, 93012 Bobigny Cedex (FR)
(72) Inventeur: ALBOU, Pierre, 93012 Bobigny Cedex (FR); SANCHEZ, Vanesa, 93012 Bobigny Cedex (FR); COURCIER, Marine, 93012 Bobigny Cedex (FR)
(74) Mandataire: Valeo Visibility
(86) Numéro de dépôt international: PCT/EP2017/066182
(87) Numéro de publication internationale: WO 2018/002252

(56) Documents cités:
- EP-A1- 2 677 232
- EP-A1- 3 026 705
- WO-A1-2008/109296
- WO-A1-2010/014032
- WO-A1-2012/156121
- CN-A- 105 258 057
- DE-A1- 10 315 133
- DE-A1-102007 052 742
- DE-A1-102010 047 376
- DE-A1-102012 008 930
- US-A1- 2011 205 049
- US-A1- 2015 043 239
- US-B2- 7 521 872

## Description

La présente invention se rapporte au domaine des dispositifs lumineux de véhicule émettant des faisceaux lumineux formés à partir de plusieurs images.

Les documents WO 2010/014032A1, DE 102012008930 A1, DE 102010047376 A1 et WO 2008/109296 A1 décrivent des dispositifs lumineux utilisant des sources lumineuses comprenant des zones activables sélectivement.

Il est connu des dispositifs lumineux de véhicule générant des faisceaux lumineux d'éclairage de la route permettant d'associer différentes images d'une ou de plusieurs sources lumineuses pour former le faisceau lumineux correspondant. Ces dispositifs permettent d'adapter le faisceau lumineux en allumant ou en éteignant certaines de ces parties. En augmentant, le nombre de parties permettant de former le faisceau lumineux, il est possible d'affiner la possibilité d'adaptation de ce dernier.

Cependant, compte tenu des dimensions physiques des éléments permettant de générer une partie du faisceau lumineux, notamment les sources lumineuses et les optiques associées, l'homme du métier est confronté à une limitation minimale dans la taille des plus petite portions constituant ce type de faisceau lumineux. Cela limite donc les possibilités d'affiner la forme du faisceau.

Un problème visé par la présente invention est donc d'améliorer l'adaptabilité du faisceau, notamment dans sa forme.

Aussi un premier objet de la présente invention, telle que définie par la revendication 1, est un module lumineux, notamment de véhicule, ce module lumineux comprenant :
- une source lumineuse à semi-conducteur comprenant une pluralité d'unités électroluminescentes de dimensions submillimétriques, les unités étant réparties dans différentes zones lumineuses activables sélectivement,
- au moins une optique de mise en forme, apte à recevoir les rayons lumineux émis par ces zones lumineuses activables sélectivement et à les dévier hors du module lumineux, l'optique de mise en forme étant agencée de manière à former une image de la source lumineuse comprenant une pluralité de pixels,
la source lumineuse étant configurée et l'optique de mise en forme étant agencée de manière à ce qu'au moins une partie de ces pixels présentent une ouverture angulaire d'au plus 1° dans au moins une direction donnée.

Ainsi, le module lumineux selon l'invention est apte à émettre un faisceau lumineux formé par l'image de la source lumineuse. Cette image-ci présente une forme précise en raison de la faible ouverture angulaire des pixels qu'elle comprend.

Par ailleurs, en éteignant ou en allumant les pixels requis par la forme du faisceau lumineux, on peut adapter facilement et finement ce faisceau lumineux.

Egalement, compte tenu de la faible ouverture angulaire des pixels, il est possible par simple extinction de certains pixels et allumage d'autres pixels de former successivement deux images de formes identiques mais ayant une position décalée. Cela sera perçu par le conducteur comme un déplacement d'un même faisceau. Compte tenu de la faible ouverture angulaire des pixels, ce déplacement sera perçu comme fluide. Le décalage minimal entre deux images correspondant en effet à l'ouverture angulaire des pixels, celle-ci étant inférieure ou égale à 1°.

On peut ainsi réaliser un déplacement apparent d'un faisceau lumineux sans dispositif mécanique de déplacement, tout en ayant un déplacement d'une fluidité proche d'un déplacement obtenu avec des moyens mécaniques, tels que des correcteurs ou des actionneurs.

Par exemple, il est possible de réaliser un faisceau lumineux présentant une ligne de coupure, notamment horizontale, et d'ajuster la position de cette ligne de coupure par simple allumage ou extinction d'au moins un segment de l'image comportant plusieurs pixels alignés. Cela peut notamment être réalisé de manière à ajuster la hauteur d'un faisceau de croisement, comme dans le cas de la correction manuelle, ou encore de régler la position de celui-ci en fonction des accélérations ou décélérations du véhicule.

L'invention tire également partie de l'utilisation comme source lumineuse d'une source lumineuse à semi-conducteur comprenant une pluralité d'unités électroluminescentes de dimensions submillimétriques. Les unités de la source lumineuse sont réparties dans les zones lumineuses activables sélectivement.

Compte tenu de la dimension submillimétrique de ces unités, il est possible de réaliser les zones lumineuses activables sélectivement sur la même source lumineuse avec une taille suffisamment faible pour réaliser des pixels avec une ouverture angulaire d'au plus 1° et avec un espacement entre les zones lumineuses activables sélectivement très réduit, par exemple un espacement correspondant à un espacement entre deux unités successives. On évite ainsi des bandes sombres entre pixels dont la taille serait trop importante au regard de la taille de ces pixels.

Comme l'espace entre les zones lumineuses activables sélectivement est réduit au regard de la taille de ces zones lumineuses, il est possible d'avoir une image présentant des petits pixels jointifs avec une focale plus petite qu'avec par exemple une matrice de LED classiques.

Dans cette demande, l'ouverture angulaire d'une image ou d'une portion de cette image, tel qu'un pixel, correspond au faisceau lumineux qui forme cette image ou cette portion. Autrement dit c'est l'angle entre les rayons formant la limite de ce faisceau lumineux. Lorsqu'il est mentionné une ouverture angulaire selon une direction donnée, cela revient à considérer un angle limite dans un plan contenant la direction globale d'émission de lumière par le module lumineux, ce plan étant parallèle à la direction donnée. Cet angle limite correspond à l'angle entre les rayons formant la limite de ce faisceau ou cette portion de faisceau et coupant cette direction donnée et dans ce plan.

Par ailleurs, une autre avantage est qu'en utilisant une seule source lumineuse, une seule connectique peut être utilisée, en reliant directement cette source lumineuse à l'alimentation électrique. Il en résulte une économie en termes de nombre de sources lumineuses, de connexions, et de faisceaux électriques.

De plus, le module lumineux peut être agencé de manière à ce que son axe optique passe par la zone centrale.

Par ailleurs, les unités électroluminescentes de dimensions submillimétriques peuvent être des bâtonnets électroluminescents de dimensions submillimétriques. Dans un tel cas, dans la suite de la demande, la source lumineuse est appelée source lumineuse à bâtonnets.

Le module lumineux selon l'invention peut optionnellement comprendre une ou plusieurs des caractéristiques suivantes :
- au moins certains pixels présentent une ouverture angulaire d'au plus 0,6°, de préférence d'au plus 0,4° dans au moins une direction donnée ; cela permet de générer un mouvement apparent du faisceau lumineux avec une précision encore plus proche de ce qui pourrait être obtenu avec des moyens d'actionnement mécaniques et qui est difficilement, voire non atteignable, avec d'autres types de sources ;
- au moins certains pixels présentent une ouverture angulaire d'au plus 0,1° dans au moins une direction donnée ; cela permet de générer un mouvement apparent du faisceau lumineux avec une précision au moins égale à ce qui pourrait être obtenu avec des moyens d'actionnement mécaniques ;
- tous les pixels présentent, dans au moins une direction donnée une ouverture angulaire d'au plus 1°, de préférence d'au plus 0,6°, de préférence d'au plus 0,4°, de préférence d'au plus 0,1° ; notamment l'ensemble du faisceau lumineux émis par le dispositif lumineux peut être formé par ces pixels ; dans ces différents cas, la résolution est d'autant meilleure que l'ouverture angulaire est faible.

"Z. Selon l'invention, la source lumineuse et l'optique de mise en forme sont agencées de manière à ce que chaque pixel est une image de l'une des zones lumineuses activables sélectivement ; notamment, chaque zone lumineuse est apte à former un et seulement un pixel ; de ce fait l'alimentation électrique ou non de l'une des zones lumineuses activables sélectivement, permet de l'allumer ou de l'éteindre et donc de faire apparaître ou non le pixel correspondant dans l'image ; on réalise ainsi une image avec une zone comprenant plusieurs pixel, permettant de piloter plus facilement sa forme, et donc celle du faisceau lumineux.

Optionnellement, les zones lumineuses activables sélectivement ont une taille inférieure ou égale à 350 micromètres, notamment inférieure ou égale à 100 micromètres ; la source lumineuse à unités électroluminescentes submillimétriques, notamment selon les réalisations où celle-ci est une source lumineuse à bâtonnets, est avantageuse pour une telle réalisation, qui permet d'avoir un module lumineux moins encombrant.

Selon l'invention, les zones lumineuses activables sélectivement sont agencées de manière à ce que l'image de la source lumineuse comprenne une zone centrale et au moins une zone excentrée entre ladite zone centrale et des bords de l'image de la source lumineuse. Optionnellement, la majorité des pixels est répartie dans ladite zone centrale; cette réalisation est plus économique car on limite l'agencement en zone lumineuse à l'endroit où il est le plus important d'avoir une bonne résolution d'image, en particulier autour du centre d'un faisceau lumineux d'éclairage d'un véhicule automobile ;
- Selon l'invention, la pluralité de pixels est répartie dans la zone centrale et dans la zone excentrée, les pixels à l'intérieur de la zone centrale étant plus petits que ceux situés à l'extérieur de la zone centrale ; la résolution est ainsi améliorée sur ces deux zones mais plus précisément au centre ; la résolution de l'ensemble du faisceau est meilleure que pour la réalisation de l'alinéa précédent, tout en permettant une réalisation plus simple des zones lumineuses activables sélectivement.

Optionnellement, le dispositif lumineux comprend une ou plusieurs des caractéristiques suivantes :
zones lumineuses activables sélectivement aptes à participer à la formation de ladite zone centrale sont agencées de manière à ce que l'amplitude verticale à l'intérieur de laquelle ladite zone centrale peut être formée est d'au moins 6° ; cela permet, notamment dans le cadre d'un faisceau de croisement de réaliser un mouvement apparent vertical du faisceau lumineux, de manière à corriger la hauteur de ce dernier de manière dynamique en fonction des conditions de circulation ;
- l'amplitude verticale de l'alinéa précédent est d'au moins 8° ; ainsi en plus d'une correction dynamique, il est possible de régler le faisceau pour qu'il puisse réaliser, selon ce réglage, ou une fonction code ou une fonction ville, qui est également un faisceau avec une ligne de coupure mais réglée plus bas en hauteur, ou encore une fonction autoroute, qui est également un faisceau avec une ligne de coupure mais réglée plus haut en hauteur ;
- l'amplitude verticale de l'alinéa précédent ou celui le précédent est d'au moins 14° ; ainsi en plus d'une correction dynamique, il est possible de réaliser le réglage d'ajustement de la hauteur de référence du faisceau, cette hauteur de référence étant notamment celle qui est établie à l'horizontale et à l'arrêt, et autour de laquelle s'effectue la correction dynamique ; cela permet par exemple d'étalonner la hauteur de référence du module lumineux dans un véhicule ;
- selon l'alinéa précédent le module lumineux peut comprendre un dispositif de pilotage des zones lumineuses activables sélectivement qui soit apte à être programmé pour associer une configuration d'activation donnée des zones lumineuses à une configuration d'activation de référence ;
- la programmation du dispositif de pilotage visé à l'alinéa précédent peut être faite au montage, en enregistrant cette association une fois la ligne de coupure à la hauteur souhaitée ; il n'est ainsi plus nécessaire d'avoir des correcteurs manuels ;
- selon les deux alinéas précédents, le dispositif de pilotage peut être agencé pour recevoir un signal de commande d'étalonnage et être apte à associer une configuration d'activation donnée des zones lumineuses à une configuration d'activation de référence en fonction du signal de commande de référence ; cela permet ainsi de régler la position de référence du faisceau autrement que par rapport à des jeux de montage, notamment en fonction de la charge du véhicule ;
- le module lumineux comprend un dispositif de pilotage comprenant un récepteur de signal, notamment un signal électrique, et comprenant une mémoire associant la configuration de référence à un signal donné ;
- selon l'alinéa précédent
- les zones lumineuses activables sélectivement aptes à participer à la formation de ladite zone centrale sont agencées de manière à ce que l'amplitude horizontale à l'intérieur de laquelle ladite zone centrale peut être formée est d'au moins environ 10°, d'au moins 20°, d'au moins 40° ou d'au moins 90° ;
   cela permet, notamment dans le cadre d'un faisceau de croisement de réaliser un mouvement apparent horizontal du faisceau, de manière à corriger celui-ci soit à des fins de réglage, notamment de manière dynamique en fonction par exemple des virages ; par exemple, pour réaliser un faisceau route sélectif, il faut un minimum de 10°, l'ouverture horizontale pouvant être d'au moins 40° pour une résolution fine sur l'ensemble de ce faisceau
   ; selon un autre exemple, pour réaliser un faisceau de croisement dont la position est ajustée en fonction des virages, il faut un minimum de 20° ; l'ouverture horizontale peut être d'au moins 90° pour une résolution fine sur l'ensemble d'un faisceau de croisement ;
- la source lumineuse comprend un groupe central de zones lumineuses activables sélectivement, les zones lumineuses activables sélectivement formant les bords du groupe central correspondant aux pixels formant les bords de la zone centrale ; c'est un exemple de réalisation de la zone centrale permettant de piloter plus facilement l'alimentation de la source lumineuse ; on facilite ainsi ma réalisation d'un mouvement apparent vertical à la zone centrale ;
- le groupe central est agencé en une matrice centrale de zones lumineuses ; l'agencement en matrice facilite la commande sélective des zones lumineuses pour à l'image formant le faisceau lumineux une forme donnée ;
- la matrice centrale est de forme rectangulaire ou carrée ;
- la matrice centrale est agencée de manière à ce que toutes les lignes de zones lumineuses n'aient pas le même nombre de colonnes ; par exemple, la matrice centrale peut s'inscrire dans une ellipse, ou une autre forme, dont les bords coïncident avec les zones lumineuses des bords de la matrice ;
- la source lumineuse comprend une matrice centrale de zones lumineuses, les zones lumineuses formant un troisième bord de la matrice centrale correspondant aux pixels les plus à droite aptes à être allumés pour former la zone central, les zones lumineuses d'un deuxième bord de la matrice centrale opposé à ce premier bord correspondent aux pixels les plus gauche apte à être allumés pour former la zone central, l'angle entre ces pixels les plus à droite et ces pixels les plus à gauche correspondant à l'amplitude horizontale à l'intérieur de laquelle ladite zone centrale peut être formée ; c'est un exemple de réalisation de la zone centrale permettant de piloter l'alimentation de la source lumineuse pour donner un mouvement apparent horizontal à la zone centrale ;
- l'ouverture angulaire des pixels est identique dans au moins deux directions ; cela permet de réaliser un mouvement apparent précis dans ces deux direction ; notamment ces directions peuvent être une direction verticale et une direction horizontale, pour améliorer la résolution à la fois de mouvements horizontaux et de mouvements verticaux ;
- les pixels et/ou les zones lumineuses présentent une forme carrée, rectangulaire, triangulaire et/ou trapézoïdale, cela facilite la formation en matrice de l'image de la source lumineuse ;
- le pavage de l'image et/ou de la zone centrale par les pixels est périodique ; les pixels sont ainsi agencés selon une matrice comportant des rangées et des colonnes de pixels identiques ; cela permet de diminuer les coûts de fabrication de la lumineuse, notamment s'il s'agit d'une source lumineuse à bâtonnets, en particulier lorsque l'image d'une zone lumineuse forme l'image d'un pixel ;
- les pixels sont de formes et/ou de tailles différentes dans l'image et/ou dans la zone centrale ; le pavage est ainsi dit apériodique, certains des pixels ne pouvant être obtenus par déplacement répété d'un même motif de base de pixel sur cette image et/ou cette zone centrale ; il est néanmoins possible d'avoir dans des portions de cette image ou de cette zone centrale ou le pavage est périodique ; ces réalisations permettent de diminuer le nombre de pixels selon l'endroit de l'image et donc de simplifier la réalisation de la source lumineuse à bâtonnets en particulier l'adressage de ses zones lumineuses ;
- les zones lumineuses sont séparées par des murets opaques ou réfléchissants ou diffusants ; c'est un moyen de réalisation permettant la formation de pixel nettement délimités, facilitant ainsi la formation de l'image ;
- la source lumineuse comprend un substrat sur lequel sont agencés directement les unités électroluminescentes et les murets ; cela facilite l'intégration des murets dans la source lumineuse ;
- la source lumineuse est une source lumineuse à bâtonnets et comprend un substrat depuis lequel s'étendent les bâtonnets et les murets ; cela facilite l'intégration des murets dans la source lumineuse à bâtonnets ;
- les murets sont obtenus par croissance cristalline d'un matériau opaque ; ils peuvent être ainsi d'une taille comparable à celle des bâtonnets, rendant la zone de séparation entre les zones lumineuse fine au regard de la taille de la zone lumineuse ;
- la source lumineuse comprend un moyen de connexion destiné à être connecté directement ou indirectement à une alimentation électrique, par exemple la batterie d'un véhicule, ce moyen de connexion étant agencé pour alimenter électriquement et indépendamment les différentes zones lumineuses ; la source lumineuse peut ainsi recevoir l'alimentation électrique des différentes zones lumineuses depuis un seul point de connexion ;
- le substrat comprend une cathode reliée au ou formant un pôle négatif du moyen de connexion ; il s'agit d'une connexion simple de la source lumineuse ;
- la source lumineuse comprend au moins autant d'anodes que de zones lumineuses, chaque anode étant agencée de manière à être en contact avec chacune des unités d'une seule et même zone lumineuse, notamment chaque anode étant connectée à une ou plusieurs bornes positives du moyen de connexion ou formant chacune une borne positive du moyen de connexion ; il s'agit d'un exemple de réalisation compact et simple de la connexion de chaque zone lumineuse, compacité d'autant plus améliorée lorsque les anodes sont connectées au même moyen de connexion ;
- chaque anode est formée par une couche conductrice déposée au-dessus du substrat, du côté des unités, et joignant électriquement les unités les unes aux autres ; il s'agit d'un exemple de réalisation davantage compact de la source lumineuse ;
- la source lumineuse est montée directement ou indirectement sur une carte électronique comprenant un dispositif de pilotage apte à alimenter sélectivement les zones lumineuses en fonction d'un signal donné, notamment un signal électrique ; il est ainsi possible d'envoyer un signal de commande correspondant à une forme donnée de faisceau lumineux, comprenant une répartition spatiale de l'intensité lumineuse, et de retranscrire celui-ci en une activation, éventuellement d'une intensité donnée, ou une désactivation des différentes sources lumineuses de manière sélective ; par exemple le dispositif de pilotage peut comprendre un multiplexeur comprenant une puce de décodage, cette dernière permettant de retranscrire le signal de commande en la commande d'activation et/ou de désactivation des sources lumineuses ;
- la source lumineuse est montée directement ou indirectement sur une première face de la carte électronique et dispositif de pilotage est monté directement ou indirectement sur une deuxième face de la carte électronique ; cela permet de gagner en compacité ;
- l'optique de mise en forme comprend une optique de projection de la lumière émise par la source lumineuse ; c'est un moyen simple de former une image pixélisée avec la source lumineuse qui comprend des zones lumineuses sélectivement activable ;
- l'optique de projection crée une image réelle, et éventuellement anamorphosée, d'une partie du dispositif ; par exemple cette partie peut être : la source lumineuse elle-même, un cache écrantant une partie des rayons lumineux émis par la source lumineuse, une image intermédiaire de la source lumineuse ;
- l'image réelle visée à l'alinéa précédent est créée par l'optique de projection à une distance très grande devant les dimensions du module lumineux ; par exemple l'image peut être créée à l'infini ou à une distance finie d'un rapport de l'ordre d'au moins 30 fois, de préférence 100 fois, la plus grande dimension du module lumineux ;
- cette optique de projection peut consister en un ou plusieurs réflecteurs, ou bien en une ou plusieurs lentilles, ou encore en une combinaison de ces possibilités ;
- l'image de la source lumineuse forme au moins une partie d'un faisceau d'éclairage, comprenant notamment une ligne de coupure ; l'invention est particulièrement adaptée à ce type de faisceau car elle permet un changement de position de la ligne de coupure sans utilisation d'un actionneur mécanique ;
- la zone centrale comprend ladite ligne de coupure.

Un autre objet de l'invention est un dispositif lumineux de véhicule comprenant au moins un module lumineux selon l'invention. Ce dispositif lumineux peut être un projecteur de véhicule.

Ce dispositif lumineux permet en particulier de réaliser une fonction photométrique, notamment réglementaire, tel qu'un faisceau de croisement, un faisceau route, un faisceau autoroute.

Lorsque le dispositif lumineux et le module lumineux sont agencés de manière à réaliser un déplacement apparent du faisceau lumineux de manière à ajuster la position de ce faisceau comme dans le cas de la correction manuelle, le dispositif lumineux peut être dépourvu d'un système de réglage mécanique de l'orientation du module.

Cependant, même dans un tel cas, le dispositif lumineux peut comprendre en plus un système de réglage mécanique de l'orientation du module lumineux, par exemple une vis de réglage. Ainsi, si le dispositif de pilotage des sources lumineuses devient défectueux, il est possible d'utiliser le système de réglage mécanique, qui forme donc un système de secours.

D'ailleurs, certaines réglementations imposent que les dispositifs lumineux aient un système de réglage mécanique. Il est donc dans ce cas possible d'équiper le dispositif lumineux d'un module lumineux selon l'invention et d'un système de réglage mécanique.

C'est par exemple le cas aux Etats-Unis avec la réglementation FMVSS108, qui impose notamment que chaque projecteur avant de véhicule doit être équipé, une fois monté dans le véhicule, d'un système mécanique de réglage horizontal et vertical du faisceau lumineux, accessible sans démontage d'autres parties du véhicule, et actionnable avec un simple outil.

Un autre objet de l'invention est un véhicule comprenant un dispositif lumineux de véhicule et/ou un module lumineux selon l'invention.

La source lumineuse, y compris lorsque la source lumineuse est une source lumineuse à bâtonnets, peut optionnellement présenter une ou plusieurs des caractéristiques suivantes :
- les unités présentent une épaisseur comprise entre 0,1 micromètres (µm) et 2 µm, notamment entre 1,4 µm et 1,6 µm ; cela permet d'augmenter la surface émettrice de lumière et confère un meilleur rendement lumineux à la source lumineuse ; par exemple, les unités sont des bâtonnets de 1µm d'épaisseur ;
- les unités, en particulier lorsque ces unités sont des bâtonnets, présentent par exemple une hauteur comprise entre 2 µm et 10 µm ; cela permet d'augmenter la surface émettrice de lumière et améliore le rendement lumineux de la source lumineuse ; par exemple, les unités sont des bâtonnets de 8 µm de hauteur ;
- les unités sont écartées les unes des autres d'une distance entre 1 µm et 35 µm, préférentiellement entre 3 µm et 30 µm, préférentiellement entre 3 et 10 µm ;
   le maximum de distance correspond à un minimum de densité en unités ; bien que ce maximum de distance ne soit pas limitatif, il confère de meilleurs résultats en termes de rendement lumineux, à savoir le rapport de la puissance optique émise sur la puissance électrique injectée, notamment pour un module lumineux automobile ;
   le minimum de 1 µm permet une réalisation plus facile de ces sources lumineuses, en particulier dans le cas d'une source lumineuse à bâtonnets, cela facilite la réalisation de la croissance des bâtonnets ;
   néanmoins, lorsque les unités présentent une certaine hauteur, notamment lorsque ces unités sont des bâtonnets, et que ces unités sont trop denses, l'émission de certaines unités peut-être gênée par la présence d'autres unités, qui les écrantent ; le rendement de la source lumineuse est significativement amélioré avec une distance entre unités d'au moins 3µm ;
- les unités sont des bâtonnets qui s'étendent depuis le substrat selon une direction privilégiée ;
- les unités comprennent un nitrure de métal, notamment un nitrure de gallium, et/ou le substrat est essentiellement à base de silicium ; les nitrures de métal et en particulier de gallium permettent d'obtenir de bons résultats en termes d'émission de lumière ; le silicium permet de réaliser une source lumineuse, et donc un dispositif lumineux, moins onéreuse que les LED classiques ;
- la source lumineuse comprend une couche d'un luminophore agencée au-dessus des unités de manière à ce que le luminophore reçoive les rayons émis par les unités et émette à son tour des rayons lumineux, correspondant aux rayons lumineux émis par la zone lumineuse correspondante.

L'invention a également pour objet un procédé de commande d'un module lumineux ou d'un dispositif lumineux selon l'invention, le procédé comprenant :
- une étape d'envoyer au moins un signal de commande correspondant à un faisceau lumineux donné et/ou une position requise, et
- une étape de sélectionner les zones lumineuses à alimenter électriquement en fonction de ce signal de commande.

Le procédé de commande selon l'invention peut optionnellement comprendre une ou plusieurs des caractéristiques suivantes :
- le signal de commande est envoyé par l'activation d'une commande par l'intermédiaire d'une interface utilisateur ;
- le signal de commande est envoyé par un capteur et/ou un calculateur que comprend le module lumineux, le dispositif lumineux et/ou le véhicule ;
- l'étape de commande comprend les sous-étapes suivantes :
   o la détermination de la position requise pour le faisceau lumineux associé au signal de commande,
   o l'extinction et l'allumage des zones lumineuses pour conférer au faisceau lumineux la position requise ;
- les zones lumineuses sont allumées et/ou éteintes par rangées et/ou colonne par colonne entre la position initiale du faisceau lumineux et la position requise de ce faisceau lumineux par le signal de commande ; on confère ainsi un déplacement apparent au faisceau lumineux ayant une fluidité proche, voire identique, de celle d'un actionneur mécanique ;
- le signal de commande est un signal électrique, un signal véhiculé par ondes électromagnétiques, notamment par Wifi ou par infrarouge ;
- le procédé comprend une étape d'étalonnage comprenant les sous-étapes suivantes :
   o la réception d'un signal de commande dit signal de commande d'étalonnage et passage consécutif aux sous-étapes suivantes,
   o la détermination de la position requise pour le faisceau lumineux,
   o la détermination d'une configuration donnée de zone lumineuses devant être éteintes ou allumées pour conférer au faisceau lumineux la position requise,
   o l'enregistrement de cette configuration donnée, notamment dans une mémoire d'un dispositif de pilotage des zones lumineuses activables sélectivement, comme une configuration de référence ;
- le signal de commande d'étalonnage est envoyé par un calculateur qui en fonction de la charge détermine la configuration donnée requise ;
- le signal de commande d'étalonnage est généré au démarrage, notamment si le véhicule est horizontal ; notamment un calculateur, en fonction d'images acquises par une caméra, peut déterminer la hauteur de l'horizon et quelle configuration donnée est requise pour régler la hauteur de référence du faisceau ; ainsi, à chaque démarrage, selon la charge du véhicule, le calculateur déterminera le réglage de référence, notamment autour duquel pourra se faire une correction dynamique du faisceau lumineux.

Le calculateur peut être agencé dans le module lumineux, le dispositif lumineux ou le véhicule selon l'invention.

A noter que dans les différents objets de l'invention, le dispositif de pilotage est préférentiellement compris dans le dispositif lumineux ou dans le module lumineux.

Sauf indication contraire, lorsqu'ils sont employés pour l'agencement du module lumineux ou du dispositif lumineux, les termes « avant », « arrière », « inférieur », « supérieur », « côté », « longitudinal », « transversal » se réfèrent au sens d'émission de lumière hors du module lumineux ou du dispositif lumineux. Lorsqu'ils sont employés pour un faisceau lumineux, ces termes s'appliquent par rapport à une projection de ce faisceau sur un écran vertical à distance de ce module lumineux ou de ce dispositif lumineux.

D'autres caractéristiques et avantages de l'invention apparaîtront à la lecture de la description détaillée des exemples non limitatifs qui suivent, pour la compréhension de laquelle on se reportera aux dessins annexés, parmi lesquels :
- la figure 1 est une section verticale longitudinale d'un dispositif lumineux selon l'invention ;
- la figure 2 représente une vue en coupe schématique d'une source lumineuse à bâtonnets d'un dispositif lumineux selon l'invention ;
- la figure 3 représente une vue en coupe schématique de dessus de la figure 2 ;
- la figure 4 représente la projection sur un écran vertical, notamment à 25 mètres, d'un faisceau de croisement émis par un module lumineux ou un dispositif lumineux de véhicule selon l'invention, ainsi que deux autres positions de réglage vertical possibles ;
- la figure 5 représente la projection sur un écran vertical, notamment à 25 mètres, d'un faisceau émis par un module lumineux ou un dispositif lumineux de véhicule selon l'invention, avec deux possibilités de réglage en faisceau de croisement en trafic à droite ou bien en trafic à gauche ;
- la figure 6 représente la projection sur un écran vertical, notamment à 25 mètres, d'un faisceau de croisement émis par un module lumineux ou un dispositif lumineux de véhicule selon l'invention ainsi que deux autres positions de réglage horizontal possibles ;
- la figure 7 représente, selon une réalisation de l'invention, la projection sur un écran vertical, notamment à 25 mètres, d'une zone centrale avec les différents pixels pouvant être formée dans celle-ci.

A noter que ces figures sont schématiques ; les échelles ne doivent pas être prises en considération entre les différents éléments.

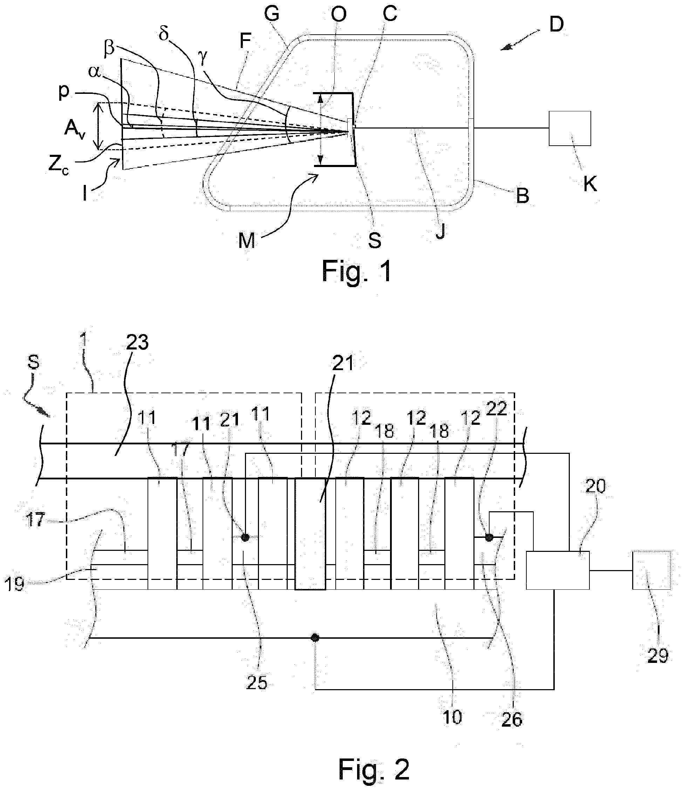

La figure 1 illustre un exemple de dispositif lumineux D de véhicule selon l'invention comprenant un module lumineux M selon l'invention. Ce dispositif lumineux D est un projecteur apte à émettre un faisceau lumineux d'éclairage, notamment un faisceau de croisement F.

Le dispositif lumineux D comprend un boitier B fermé par une glace transparente G, délimitant ainsi un volume intérieur.

A l'intérieur de ce volume intérieur, est agencé le module lumineux M. Ce dernier comprend une source lumineuse S, qui émet les rayons permettant de former, dans cet exemple, l'intégralité du faisceau de croisement F. Comme il sera détaillé plus loin, cette source lumineuse S comprend différentes zones lumineuses activables sélectivement, c'est-à-dire pouvant être alimentées électriquement ou éteintes indépendamment en fonction d'un signal de commande reçu.

Le module lumineux M comprend au moins un connecteur C relié à la source lumineuse S et destiné à être connecté à une alimentation électrique K pour alimenter électriquement la source lumineuse S, notamment via un unique faisceau électrique J.

Le module lumineux M comprend une optique de mise en forme O agencée pour projeter l'image de la source lumineuse S, dite ci-après image globale I, de manière à former le faisceau de croisement F. Dans cet exemple, cette optique de mise en forme O est une lentille convergente focalisée au niveau de la source lumineuse S. Néanmoins l'invention n'est pas limitée à ce type d'optique, et l'optique de mise en forme pourrait également être choisie parmi un réflecteur, une combinaison de lentilles, une combinaison de réflecteurs, et une combinaison de lentilles et de réflecteurs.

L'image globale I comprend une pluralité de pixels p, au moins dans une zone centrale Zc de l'image globale I.

Comme on peut le voir sur la figure 1, la taille de l'image globale I est fonction de la distance à laquelle la projection est effectuée depuis le module lumineux M. Aussi dans le domaine de l'éclairage automobile, il est courant d'exprimer la taille de l'image non pas en unité de distance mais en terme d'ouverture angulaire, qui elle est valable quelle que soit la distance au module optique.

Ainsi, la taille de l'image globale I correspond à une ouverture angulaire y du faisceau de croisement F. On peut observer également que la zone centrale Zc dans l'image globale I correspond également à une ouverture angulaire β.

De la même manière, chacun des pixels p de cette zone centrale Zc a également une taille définie par une ouverture angulaire α.

Selon l'invention, l'ouverture angulaire α des pixels p est au plus de 1°, au moins dans la zone centrale Zc. Dans cet exemple, celle-ci est d'au plus 0,4°.

Le module lumineux M selon l'invention est agencé de manière à ce que les zones lumineuses soient aptes à être activées de manière à ce que la zone centrale Zc puisse, selon les zones lumineuses activées, apparaître à l'intérieur d'une fenêtre dans l'image globale I qui correspond à une amplitude verticale Av.

Autrement dit, cette amplitude verticale Av correspond à l'ouverture angulaire d'une zone où la zone centrale peut être formée par le module lumineux. Cette ouverture angulaire est appelée ci-après ouverture angulaire de positionnement δ.

L'agencement du module lumineux M, et en particulier de l'optique de mise en forme O et de la source lumineuse S est telle, que chaque pixel p correspond à une image d'une zone lumineuse de la source lumineuse S et que cette zone lumineuse ne forme qu'un pixel. Ainsi à une matrice de pixels p projetables dans l'image correspond une matrice de zone lumineuses activables dans la source lumineuse S.

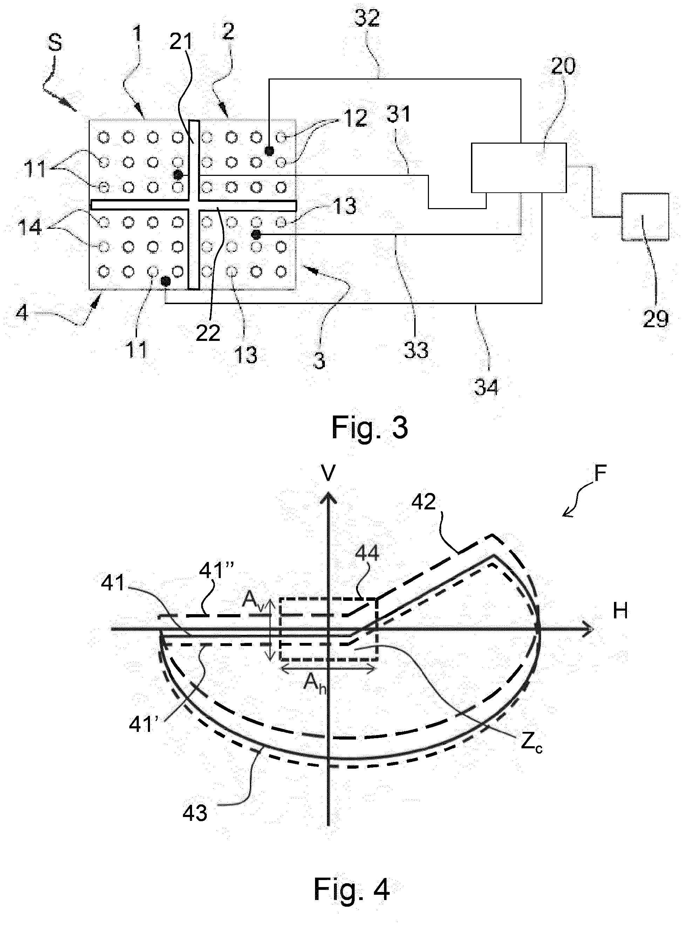

Ces zones lumineuses sont détaillées dans les figures 2 et 3, qui représentent schématiquement une portion de la source lumineuse S agencée dans le dispositif lumineux D.

Dans cet exemple de réalisation, cette source lumineuse S est une source lumineuse à bâtonnets, dont les bâtonnets forment des unités électroluminescentes.

Comme illustré en figure 2, la source lumineuse S, ici représentée en coupe, comprend un substrat 10 à partir duquel s'étendent selon une direction privilégiée des bâtonnets 11, 12, 13, 14.

Ce substrat 10 est, notamment dans cet exemple, du silicium, ce qui représente un coût bien moindre à celui des LED classiques, dans lesquelles les substrats sont en saphir. Les bâtonnets 11, 12, 13, 14, peuvent être obtenus par croissance cristalline sur ce substrat 10.

Les bâtonnets 11, 12, 13, 14, sont agencés de manière à former des bâtonnets en un matériau semi-conducteur électroluminescent. Les bâtonnets 11, 12, 13, 14, peuvent par exemple être formés essentiellement de nitrure de gallium.

Par exemple, ces bâtonnets 11, 12, 13, 14, comprennent une âme en matériau semi-conducteur apte à être dopé en électrons, autour de laquelle est formée une première couche en matériau semi-conducteur apte à présenter des déficits en électrons, dans ce cas on parle parfois de couche dopé en « trous » ou en charges positives. A l'interface de cette âme et de cette première couche, se forme une couche intermédiaire où se recombinent les électrons et les déficits en électrons. Ainsi, chaque bâtonnet 11, 12, 13, 14, est un élément semi-conducteur électroluminescent.

Une couche de nucléation 19 est formée sur le substrat 10 et autour des bâtonnets 11, 12, 13, 14.

Les bâtonnets 11, 12, 13, 14, sont ici distants d'environ 30 µm et ont chacun une hauteur, prise depuis la couche de nucléation 19 jusqu'à leur sommet, de 2,5 µm. Leur épaisseur, qui correspond ici à la largeur des bâtonnets en figure 1, est de 1,5 µm.

La source lumineuse S comprend donc essentiellement un substrat 10 formant une plaque hérissée d'une multitude de petits bâtonnets 11, 12, 13, 14, électroluminescents et submillimétriques, à savoir dont la plus grande dimension est inférieure au millimètre.

Selon la présente invention, la source lumineuse S est divisée en plusieurs zones lumineuses 1, 2, 3, 4, correspondant à une répartition de l'ensemble des bâtonnets 11, 12, 13, 14.

Entre chaque bâtonnets 11, 12, 13, 14 d'une même zone 1, 2, 3, 4, est déposée une couche électriquement conductrice, joignant électriquement ces bâtonnets, formant ainsi une anode distincte 25, 26, pour chacune des zones lumineuses 1, 2, 3, 4.

Les quatre anodes 25, 26, ainsi formées sont en contact avec la couche de nucléation 19, qui elle-même est en contact avec la cathode formée par le substrat 10.

Ainsi, en connectant les anodes 25, 26 et la cathode 10 à une source d'alimentation, on peut alimenter en électricité indépendamment chacune des différentes zones lumineuses 1, 2, 3, 4.

Selon une réalisation de l'invention, chaque anode est connectée à une ou plusieurs bornes positives d'un moyen de connexion 20, destiné à être connectée à la borne positive d'une source d'alimentation électrique (non représentée) d'un véhicule. De même, la cathode 10 est connectée à la borne négative du moyen de connexion 20. Le moyen d'activation permet donc l'alimentation électrique de chacune de ces zones lumineuses 1, 2, 3, 4.

Il est donc possible de piloter cette source lumineuse S, par activation sélective de ses zones lumineuses 1, 2, 3, 4, via le moyen d'activation 20.

Le pilotage peut être réalisé par un moyen spécifique distinct du dispositif lumineux, ou bien, comme dans cet exemple réalisé par un dispositif de pilotage 29 intégré au dispositif lumineux.

Dans cet exemple, le pilotage est réalisé directement par un dispositif de pilotage 29. Ce dernier est relié d'une part au moyen de connexion 20 et d'autre part au connecteur C. le moyen de connexion 20 est lui relié à chaque anode 25, 26, via des conducteurs électriques 31, 32, 33, 34.

Le dispositif de pilotage 29 et la source lumineuse S sont montés sur une même carte de circuit imprimé, non représentée. Les conducteurs électriques 31, 32, 33, 34 sont formés par des pistes électroniques de cette carte de circuit imprimé. De même, d'autres pistes électroniques relient le moyen de connexion 20 au dispositif de pilotage 29.

Le rendement lumineux des zones lumineuses 1, 2, 3, 4, peut être amélioré en déposant une couche réfléchissante 17, 18, sur la couche de nucléation 19. Cette couche réfléchissante 17, 18, est par exemple déposée sur la couche de nucléation 19 avant croissance des bâtonnets, puis des trous sont ménagés dans cette couche réfléchissante 17, 18, ainsi que dans la couche de nucléation, avant croissance des bâtonnets 11, 12, 13, 14, sur le substrat 10.

Pour avoir un meilleur rendement lumineux, les bâtonnets des zones lumineuses peuvent avoir les caractéristiques ci-dessous :
- une épaisseur comprise entre 1,4 µm et 1,6 µm, par exemple 1 µm,
- une hauteur comprise entre 2 µm et 10 µm, par exemple 8 µm,
- une distance entre chaque bâtonnet comprise entre 3 et 10 µm.

En figure 3, seules quatre zones lumineuses, 1, 2, 3, 4 ont été représentés. Cependant, dans cet exemple la source lumineuse S comprend davantage de zones lumineuses. Ces zones lumineuses sont réalisées dans une portion centrale de la source lumineuse.

La figure 4, illustre en traits plein le faisceau de croisement F obtenu en une position donnée par l'allumage sélectif de certaines zones lumineuses.

Dans cet exemple, le motif formé par l'ensemble des zones lumineuses activées 1, 2, 3, 4 sur la source lumineuse S est directement imagé par l'optique de mise en forme O, pour réaliser l'image globale I.

Le faisceau de croisement F présente une ligne de coupure horizontale 41 sur la gauche et une ligne de coupure oblique 42 sur la droite, pour une circulation en trafic à droite. Le faisceau s'étend en-dessous de ces lignes de coupure 41, 42 jusqu'à une limite symbolisée par le bord 43. Ce bord 43 forme l'endroit où le faisceau lumineux n'est plus visible. Néanmoins à la différence des lignes de coupure 41, 42, le faisceau disparaît au niveau de ce bord 43 de manière progressive.

Selon l'invention, et dans cet exemple, il est créé un mouvement apparent du faisceau lumineux F par extinction et activation de certaines zones lumineuses.

Par exemple, la source lumineuse S comprend une matrice centrale de zones lumineuses, comprenant les zones lumineuses 1, 2, 3, et 4, de la figure 3. Les zones lumineuses de cette matrice centrale sont aptes à être alimentées en fonction de la commande réalisée par le dispositif de pilotage 29, pour former les pixels p dans la zone centrale Zc de l'image globale I.

Dans cet exemple, un motif lumineux est formé sur la source lumineuse S par les zones lumineuses activées. Les zones lumineuses activées les plus au bord de ce motif forment les limites du faisceau. Notamment, l'un des bords de ce motif lumineux est formé par une rangée de zones lumineuses, comprenant dans cet exemple les zones lumineuses 3 et 4 de la figure 3. L'image de cette rangée permet de réaliser les pixels situés sous la ligne de coupure horizontale 41 et donc formant cette dernière. Les zones lumineuses, dont les zones lumineuses 1 et 2, situées au-dessus cette rangée, forment la partie de la zone centrale Zc située en dessous de cette ligne de coupure horizontale 41.

La ligne de coupure oblique 42 est réalisée également de la même manière par un alignement de zones lumineuses activées.

De préférence, les zones lumineuses, 1, 2, 3 et 4, sont situées dans une portion centrale de la zone de la source lumineuse S. En dehors de cette portion centrale, la source lumineuse S présente également des zones lumineuses dont l'activation permet de réaliser le faisceau lumineux F.

Ainsi l'activation de plusieurs zones lumineuses forme un ensemble de pixels, qui associés de façon adjacente forment l'image globale I.

Cependant, les zones lumineuses situées dans cette portion centrale, sont de taille plus petite que celles situées dans la portion de la source lumineuse située en dehors de cette portion centrale.

Ainsi, la résolution de l'image globale I, et donc la précision du faisceau F est meilleure dans la zone centrale Zc. C'est dans cette zone centrale Zc qu'il est le plus important d'avoir une bonne résolution, car c'est au-dessus de la ligne de coupure 41 qu'apparaîtront le plus souvent les véhicules arrivant en sens inverse.

En dehors de cette zone centrale Zc, il n'est pas nécessaire d'avoir une résolution aussi bonne. Pour des raisons économiques, et de facilité de réalisation de la source lumineuse S, les zones lumineuses permettant de former les pixels en dehors de cette zone centrale Zc peuvent être réalisés avec des tailles plus grandes que celles permettant de réaliser les pixels p de la zone centrale Zc. Néanmoins on pourrait imaginer un mode de réalisation où l'ensemble des pixels de toute la source lumineuse S aurait la même taille.

Les pixels de la zone centrale Zc présentent une ouverture angulaire d'au plus de 0,4°. Ainsi en allumant la rangée de zones lumineuses situées immédiatement au-dessous des zones lumineuses inférieures 3, 4, en figure 3, il est possible de faire apparaître une ligne de pixel au-dessus de la ligne de coupure 41 précédemment formée. Dans ce cas, le faisceau lumineux F présente une ligne de coupure horizontale plus haute, et l'impression est que la ligne de coupure horizontale 41 du faisceau de croisement F a été remontée de 0,4° vers le haut.

En activant l'ensemble des zones lumineuses, situées immédiatement au-dessus des zones lumineuses permettant de former des coupures horizontales 41 et oblique 42, et en éteignant les zones lumineuses formant les bords du faisceau 43, le faisceau lumineux aura la même forme que précédemment mais sera décalé de 0,4° vers le haut. Ainsi en apparence, ce sera le même faisceau de croisement F qui aura été déplacé de 0,4° vers le haut.

Sur la figure 4 ont été représentées en traits pointillés, une image globale limite inférieure I', ainsi qu'une d'une image globale limite supérieure I" du faisceau de croisement F. Ces images globales limites I' et I" correspondent respectivement à l'image la plus basse et à l'image la plus haute qui peuvent être réalisées pour former le faisceau de croisement F, c'est-à-dire à respectivement la position la plus basse et la position plus haute qui peut être conférée au faisceau de croisement F.

Ces images globales limites ont respectivement une ligne de coupure 41' et 41", entre ces positions des lignes de coupure, correspond plusieurs rangées de pixels. Pour passer de la position la plus basse à la position la plus haute plusieurs rangées doive donc être allumées. En allumant successivement, les unes après les autres, chacune de ces rangées, par exemple celles au-dessus de la rangée de pixel p formant la ligne de de coupure 41, le module lumineux M réalise un mouvement apparent ascendant de cette ligne de coupure 41, ce mouvement étant progressif.

Selon une réalisation d'invention, les pixels dans la zone centrale peuvent être d'une ouverture angulaire α de 0,1°. Dans un tel cas, on crée, un déplacement du faisceau de croisement F, présentant une fluidité au moins égale à celle qu'on pourrait obtenir avec un module optique actionnable par des moyens mécaniques.

Sur la figure 4 est également illustrée une fenêtre 44 à l'intérieur de laquelle peut être formée la zone centrale Zc. L'ensemble des pixels susceptibles d'être activés dans cette fenêtre 44 ont la meilleure résolution. Par exemple, les pixels dans cette fenêtre 44 peuvent avoir une ouverture angulaire α de 0,1° et les pixels en dehors de cette fenêtre 44, une ouverture angulaire α de 0,4°.

Cette fenêtre présente une hauteur correspondant à l'amplitude verticale Av, et une largeur correspondant à une amplitude horizontale Ah.

L'amplitude verticale Av, qui correspond à l'ouverture angulaire verticale de positionnement δ, peut par exemple être de 8°. Plus particulièrement, comme en figure 4, une fois que la module lumineux est dans sa position d'utilisation dans un véhicule, elle peut être répartie de part et d'autre de l'horizon H entre -4° et +4°. Cela permet de réaliser un réglage dynamique de la position du faisceau de croisement F. Cela permet également :
- de passer du faisceau de croisement F à un faisceau autoroute, connu encore sous le nom de faisceau « motorway », en relevant la ligne de coupure,
- de passer du faisceau de croisement F à un faisceau ville, en abaissant la ligne de coupure ;
la correction dynamique restant possible également pour ces faisceaux autoroute et ville.

Selon une réalisation non représentée, cette amplitude verticale peut-être de 14°, à savoir comprise entre -7° et +7° de part et d'autre de l'horizon H. Dans cet exemple, la position verticale de référence du faisceau lumineux F peut être ainsi corrigée, par simple allumage et/ou extinction des zones lumineuses correspondantes, de la même manière qu'on corrige manuellement la position d'un faisceau de croisement avec des procédés mécaniques.

Ce réglage peut se faire par programmation, notamment d'un ou plusieurs processeurs de la carte électronique, une fois le dispositif lumineux monté dans le véhicule. Par exemple, en réglant la configuration de zones lumineuses éteintes ou allumées souhaitée de manière à ce que la ligne de coupure soit à la bonne hauteur, et en enregistrant cette configuration comme configuration de référence, dans le ou les processeur(s).

Ce réglage peut aussi être réalisé en fonction de la charge du véhicule. Par exemple, le multiplexeur 29 est relié à un calculateur du véhicule, ou du dispositif lumineux, qui lorsque la clé de contact du véhicule est activée mais que ce dernier n'avance pas, enclenche une procédure d'étalonnage. Le calculateur détermine alors en fonction des informations reçus par des capteurs la charge du véhicule. Ensuite, le calculateur détermine à quelle position doit être placé le faisceau de croisement F pour ne pas éblouir les conducteurs des véhicules venant en sens adverse ou des véhicules suivis. En effet, selon la charge du véhicule, son châssis et donc ses dispositifs lumineux sont plus ou moins inclinés. On réalise ainsi un réglage de la hauteur du faisceau de croisement F et en particulier de la ligne de coupure 41, en fonction de la charge du véhicule.

Alternativement, la procédure d'étalonnage peut être enclenchée manuellement, lorsque le conducteur sait que la route est horizontale, ou automatiquement quand le calculateur détermine que la route est horizontale. Le calculateur détermine ensuite en fonction des informations reçus par des capteurs, notamment une caméra, la position de l'horizon et détermine à quelle position doit être placé le faisceau de croisement F pour ne pas éblouir les conducteurs des véhicules venant en sens adverse ou des véhicules suivis. Le calculateur enregistre ensuite cette position et la configuration d'activation de zones lumineuses éteintes ou allumées associée comme position et configuration de référence. Ainsi, quelle que soit la charge du véhicule, la hauteur du faisceau sera réglée à la hauteur correcte.

Une fois cette position verticale de référence réglée, le réglage dynamique est réalisé autour de cette position de référence, par exemple entre +3° et -3° autour de cette position de référence.

Dans ce cas, le multiplexeur 29 est relié à un calculateur du véhicule, qui en fonction de données reçues par des capteurs, tels qu'une caméra, un dispositif de freinage, un dispositif d'accélération, détermine l'inclinaison du véhicule et en conséquence à quelle position doit être placé le faisceau de croisement F pour ne pas éblouir les conducteurs des véhicules venant en sens adverse ou des véhicules suivis. Ainsi en fonction de l'inclinaison du véhicule, la position du faisceau de croisement F sera réglée en temps réel, par la formation successive d'images de la source lumineuse S. On réalise ainsi un réglage dynamique de la hauteur du faisceau de croisement F et en particulier de la ligne de coupure 41.

A noter que dans cette figure 4, la zone centrale Zc présente une amplitude horizontale Ah. Celle-ci représente la largeur de la zone centrale Zc dans laquelle les pixels p présentent l'ouverture angulaire α la plus petite. Dans cet exemple, les pixels p sont allumés sur l'ensemble de cette largeur.

Selon d'autres modes de réalisation, avec une amplitude horizontale Ah plus grande, on peut également réaliser un faisceau de croisement qui pourrait être formé de manière plus ou moins décalée sur la droite ou sur la gauche, pour un réglage à droite ou à gauche du faisceau de croisement, de la même manière que ce qui est fait pour le réglage vertical du faisceau de croisement F.

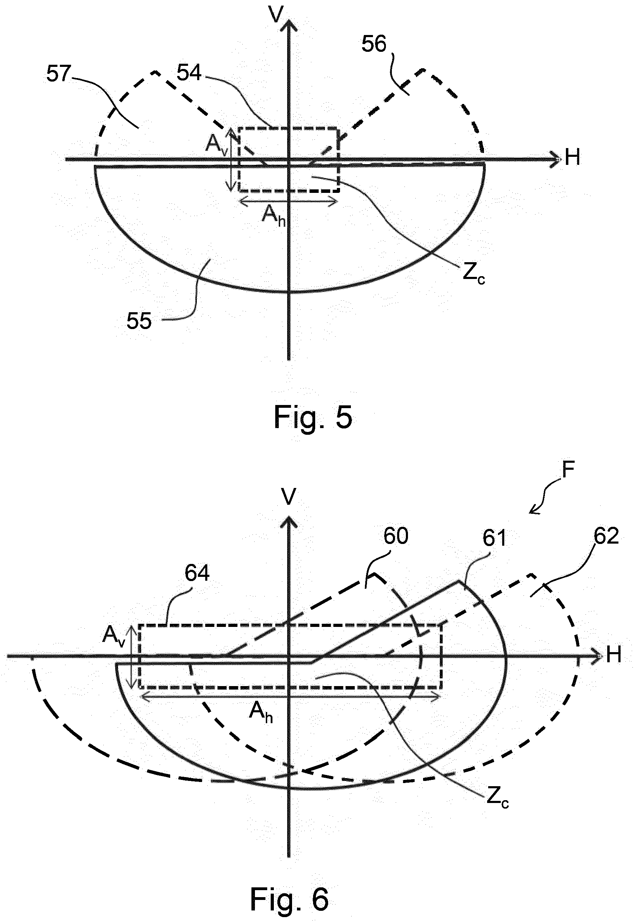

Selon un autre mode de réalisation, illustré en figure 5, le module lumineux M est agencé de manière à pouvoir former une portion basse 55 de faisceau lumineux, une portion haute droite 56 de faisceau lumineux et une portion haute gauche 57 de faisceau lumineux.

La portion basse est allumée systématiquement lors de la réalisation d'un faisceau de croisement. En revanche, selon que le véhicule roule en trafic à droite ou en trafic à gauche, l'une ou l'autre des portions hautes 56, 57, est allumée. Par exemple, la portion haute droite 56 est allumée en trafic à droite alors que l'autre portion haute 57 est éteinte.

Une fenêtre 54 ayant une amplitude verticale Av et une amplitude horizontale Ah représente la zone dans laquelle sont susceptible d'être allumés les pixels formant la zone centrale Zc ayant la meilleure résolution du faisceau croisement, tant en trafic à gauche qu'en trafic à droite.

Par exemple, l'amplitude horizontale Ah de la fenêtre 54 est de 40°, soit une ouverture angulaire de positionnement latéral de plus ou moins 20° par rapport à l'axe vertical V.

Les zones lumineuses de la source lumineuse sont agencées de la même manière que les pixels susceptibles d'être allumés. Ainsi, la source lumineuse présente des zones lumineuses réparties selon un motif de même forme que la portion basse 55, et que le dispositif de pilotage alimentera systématiquement pour la réalisation d'un faisceau de croisement.

Elle présente également un groupement de zones lumineuses réparties selon un motif de même forme que la portion haute droite 56 et un groupement de zones lumineuses réparties selon un motif de même forme que la portion haute gauche 57. Le dispositif de pilotage allumera l'un ou l'autre de ces groupements selon le sens de trafic choisi.

Il est également possible d'avoir une fenêtre 64 plus large que dans les modes de réalisation précédents pour ajuster de manière horizontale le faisceau de croisement F.

Ainsi en figure 6, le module lumineux est susceptible d'alimenter des zones lumineuses de manière à former des images d'un faisceau de croisement entre une position limite maximale à gauche 60 et une position limite maximale à droite 62. La position centrale 61 du faisceau de croisement lorsque celui-ci roule droit devant est située entre ces deux positions limites. En allumant et en éteignant successivement les zones lumineuses situées à côté des zones lumineuses formant l'image globale I précédente, il est possible de réaliser successivement des images globale I décalées sur la droite ou sur la gauche et de réaliser ainsi un mouvement apparent du faisceau de croisement vers la droite ou vers la gauche. Cette formation successive d'images peut être réalisée par le multiplexeur 29 qui reçoit du calculateur la position que doit adopter l'image globale I, en fonction par exemple de l'angle de braquage au volant. On peut ainsi réaliser un faisceau de croisement F ayant un mouvement apparent à droite ou à gauche en fonction des virages. On crée ainsi un faisceau de croisement susceptible d'avoir un mode de suivi des virages, encore appelée fonction DBL (pour « Driving Bending Light »).

Dans ce cas, la zone centrale Zc peut être formée dans une fenêtre 64 présentant l'amplitude verticale Av nécessaire à la correction verticale, c'est-à-dire une amplitude verticale Av d'au moins 8°, mais également une amplitude horizontale Ah d'au moins 20°, soit plus ou moins 10° à droite ou à gauche de l'axe vertical V.

Les différentes représentations des figures 4 à 6 peuvent néanmoins être combinées. En effet, on peut envisager une réalisation du module lumineux de manière à pouvoir réaliser des images du faisceau de croisement F en des positions différentes, et à réaliser et à faire disparaître ces images successivement de manière à avoir un mouvement apparent du faisceau lumineux F, pour suivre un virage, pour passer en trafic à droite ou à gauche, et/ou pour corriger dynamiquement la hauteur du faisceau lumineux F.

Ainsi, on obtient un module lumineux M qui bien que dépourvus d'actionnaires mécaniques, génère un faisceau de croisement susceptible d'ajustement ou de réglage dynamique de ce faisceau de croisement F, par simple activation ou désactivation de zones lumineuses de la source lumineuse.

D'une manière générale, selon une réalisation de l'invention, la source lumineuse S présente donc un agencement en zones lumineuses correspondant à l'agencement en pixels de l'ensemble des images pouvant être formées.

Ainsi selon les capacités de réglage du faisceau de croisement, dans le cas où l'image présente une zone centrale de pixels p avec une ouverture angulaire plus faible qu'en dehors de cette zone centrale, la source lumineuse S comprend une portion centrale avec des dimensions plus ou moins grande.

On peut néanmoins avoir un faisceau de croisement où tous les pixels seraient identiques c'est-à-dire où la source lumineuse aurait des zones lumineuses de taille identique. Dans ce cas, on aura une zone de grande résolution de plus ou moins 45° de part et d'autre de l'axe vertical.

Comme illustré en figures 2 et 3, la source lumineuse peut comprendre un convertisseur de lumière 23 agencé au-dessus des bâtonnets 11, 12, 13,14.

Un convertisseur de lumière comprend au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation.

Par exemple, le convertisseur 23 est un luminophore, qui peut être déposé sur le sommet des bâtonnets 11, 12, 13, 14. Sur la figure 2, les bâtonnets sont en contact affleurant avec cette couche de luminophore 23. Cette couche peut être agencée de manière plus basse sur la source lumineuse, de sorte que les bâtonnets pénètrent plus ou moins dans cette couche.

On peut ainsi réaliser les bâtonnets avec une composition chimique permettant d'émettre des rayons lumineux d'une longueur d'onde donnée, par exemple une longueur d'onde bleue, qui sera absorbée par la couche de luminophore 23 et restituée en des rayons lumineux de couleur blanche.

La séparation entre les différentes zones lumineuses 1,2, 3,4, peut être réalisée par simple activation ou désactivation de ces zones lumineuses, c'est-à-dire simplement par la connectique des bâtonnets correspondant, par exemple par le positionnement des anodes 25, 26.

Néanmoins de manière à former des pixels p plus précis dans l'image globale I, la source lumineuse peut comprendre, comme illustré en figures 2 et 3, des murets 21, 22, opaques dans cet exemple, positionnés entre chacune des zones lumineuses 1, 2, 3, 4, en particulier entre chacune des zones lumineuses de la portion centrale.

Selon des réalisations non représentées, la séparation optique des zones lumineuses pourrait être réalisée par des murets diffusants ou réfléchissants.

Ces murets 21, 22, peuvent être obtenus par croissance sur le substrat. Par exemple, il est possible de réaliser des dépôts sur le substrat 10 formant un quadrillage correspondant à ces zones lumineuses, et de réaliser ensuite une croissance cristalline verticale permettant de réaliser ces murets opaques 24. Ensuite, les bâtonnets 11, 12, 13, 14, sont réalisés par croissance avec d'autres matériaux.

La faible épaisseur de ces murets permet d'éviter ou du moins de diminuer fortement des bandes sombres dans l'image.

Pour améliorer davantage l'image globale I, l'optique de mise en forme O peut être focalisée au niveau de la source lumineuse S, de manière à ce que les pixels p soient jointifs dans l'image globale I.

Selon une réalisation non représentée, l'optique de mise en forme et la source lumineuse sont agencées de manière à ce que les zones lumineuses présentent des formes différentes des formes des pixels correspondant p.

Par exemple, la source lumineuse est inclinée par rapport à l'optique de mise en forme et les zones lumineuses sont trapézoïdales. L'optique de mise en forme est agencée de manière à ce qu'après projection, les pixels correspondant soient rectangulaires ou carrés

D'une manière générale, dans le cas où les pixels ont au plus une ouverture angulaire α d'au plus 0,4°, les zones lumineuses peuvent avoir une taille inférieure à 350 micromètres (µm), avec par exemple une optique de mise en forme O dont la focale est de 50 millimètres. Dans le cas où les pixels ont au plus une ouverture angulaire α d'au plus 0,1°, les zones lumineuses peuvent avoir une taille inférieure à 100 µm, avec par exemple une optique de mise en forme O dont la focale est de 40 millimètres.

Il est donc ainsi possible de réaliser un module lumineux M compact.

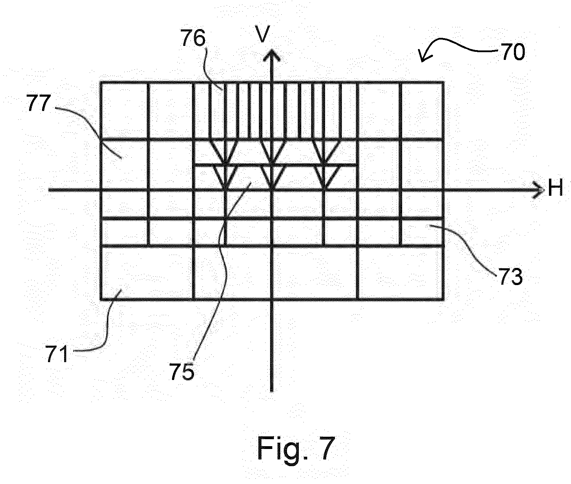

La figure 7 représente une variante de réalisation dans laquelle le pavage de la zone centrale 70 est apériodique. Selon les réalisations où l'optique de mise en forme projette l'image de la source lumineuse à bâtonnets, cette figure 7 correspond également à la répartition des zones lumineuses dans un groupe central de zones lumineuses de la source lumineuse à bâtonnets.

Dans cette variante, on peut observer que les pixels ou les zones lumineuses présentent à certains endroits une répartition périodique, mais que sur l'ensemble de la zone centrale 70 ou du groupe central, il n'y a pas de périodicité.

Par exemple comme illustré, en bas de la zone centrale 70 sont agencés une première rangée de pixels 71 qui sont toujours allumés lors de la réalisation d'un faisceau ; dans le cas d'un faisceau de croisement, ils forment la partie supérieure de la zone de code basse.

Au-dessus de cette première rangée 71, il y a une deuxième et une troisième rangées de pixels 73, qui sont allumés lors de la réalisation d'un faisceau route, et qui peuvent être allumés ou éteints lors de la réalisation d'un faisceau avec une ligne de coupure horizontale de croisement. Lorsque les pixels au-dessus de la deuxième ou de la troisième rangée 73 sont éteints, les pixels de la deuxième ou de la troisième rangée 73 permettent de réaliser la ligne de coupure horizontale respectivement d'un faisceau de croisement ou d'un faisceau autoroute. L'ouverture angulaire des pixels de ces deuxième et troisième rangées 73 est plus petite que celle des pixels de la première rangée 71.

Au-dessus de la troisième rangée 73, la zone centrale 70 présente une quatrième et une cinquième rangées de pixels triangulaires et trapézoïdaux 75, dont les pixels sont allumés ou éteints pour former la ligne de coupure oblique du faisceau de croisement ou du faisceau route, soit en trafic à droite, soit en trafic à gauche. La résolution de ces quatrième et cinquième rangées 75 est ainsi davantage améliorée.

Au-dessus de la cinquième rangée 75, est agencée une sixième rangée de pixels 76 présentant une ouverture angulaire verticale peu fine, comparé à ceux de la cinquième rangée 75, mais avec l'ouverture angulaire horizontale la plus fine de la zone centrale 70. En l'absence de véhicule en sens inverse ou suivi, ces pixels sont tous allumés en faisceau route. En revanche, lorsqu'un tel véhicule est détecté, par exemple par une caméra embarquée, un signal de commande est envoyé pour éteindre les zones lumineuses générant les pixels au niveau du véhicule détecté. On crée ainsi une zone d'ombre, présentant une coupure horizontale sous ce véhicule détecté et une coupure verticale de chaque côté de ce dernier. Le conducteur du véhicule détecté n'est ainsi pas ébloui.

Les quatrième et cinquième rangées 75 ainsi que la sixième rangée 76, forment les rangées avec les résolution les plus fines et sont plus étroites que les première, deuxième et troisième rangée. De part et d'autre des quatrième, cinquième et sixième rangées 75, 76, et au-dessus de l'horizon H, soit ici au-dessus de la troisième rangée, des groupes de quatre pixels 77 de basse résolution sont agencés. Ils sont systématiquement allumés lors de la réalisation d'un faisceau route. Ils éclairent les bas côté de la chaussée. Ils sont éteints lors de la réalisation du faisceau de croisement ou du faisceau autoroute.

La présente invention peut s'appliquer à tout type de module lumineux générant des coupures. Elle peut s'appliquer également à un module lumineux réalisant un faisceau avec des coupures verticales, pour former une tache sombre pouvant être déplacée et positionnée sur un véhicule venant en sens inverse ou un véhicule suivi. De même, la distribution lumineuse et la forme de la coupure peuvent être adaptées aux conditions climatiques et aux conditions urbaines ou encore rurales.

## Revendications

1. Module lumineux (M), notamment de véhicule, ledit module lumineux comprenant :
- une source lumineuse (S) à semi-conducteur comprenant une pluralité d'unités électroluminescentes (11, 12, 13, 14) de dimensions submillimétriques, les unités étant réparties dans différentes zones lumineuses (1, 2, 3, 4) activables sélectivement,
- au moins une optique de mise en forme (O), apte à recevoir les rayons lumineux émis par lesdites zones lumineuses (1, 2, 3, 4) et à les dévier hors du module lumineux, l'optique de mise en forme étant agencée de manière à former une image (I) de la source lumineuse comprenant une pluralité de pixels (p), chaque pixel (p) étant une image de l'une desdites zones lumineuses activables sélectivement(1, 2, 3, 4)
**caractérisé en ce que** :
- la source lumineuse (S) est configurée et l'optique de mise en forme (O) est agencée de manière à ce qu'au moins une partie de ces pixels (p) présentent une ouverture angulaire (α) d'au plus 1° dans au moins une direction donnée ; et
- les zones lumineuses activables sélectivement (1, 2, 3, 4) sont agencées de manière à ce que l'image (I) de la source lumineuse (S) comprend une zone centrale (Zc) et une zone excentrée (Zp) entre ladite zone centrale et des bords de l'image de la source lumineuse, la pluralité de pixels (p) étant répartie dans la zone centrale (Zc) et dans la zone excentrée, les pixels à l'intérieur de la zone centrale étant plus petits que ceux situés à l'extérieur de la zone centrale.

2. Module lumineux (M) selon la revendication 1, dans lequel les zones lumineuses activables sélectivement (1, 2, 3, 4) ont une taille inférieure ou égale à 350 micromètres.

3. Module lumineux (M) selon la revendication 2, dans lequel les zones les zones lumineuses activables sélectivement (1, 2, 3, 4) ont une taille inférieure ou égale à 100 micromètres.

4. Module lumineux (M) selon l'une des revendications précédentes, dans lequel les zones lumineuses activables sélectivement (1, 2, 3, 4) aptes à participer à la formation de ladite zone centrale (Zc) sont agencées de manière à ce que l'amplitude verticale (Av) à l'intérieur de laquelle ladite zone centrale peut être formée est d'au moins 6°.

5. Module lumineux (M) selon l'une quelconque des revendications précédentes, dans lequel les zones lumineuses activables sélectivement (1, 2, 3, 4) aptes à participer à la formation de ladite zone centrale (Zc) sont agencées de manière à ce que l'amplitude horizontale (Ah) à l'intérieur de laquelle ladite zone centrale peut être formée est d'au moins environ 10°, d'au moins 20°, d'au moins 40° ou d'au moins 90°.

6. Module lumineux (M) selon l'une quelconque des revendications précédentes, dans lequel au moins certains pixels (p) présentent une ouverture angulaire (α) d'au plus 0,1° dans au moins une direction donnée.

7. Module lumineux (M) selon l'une quelconque des revendications précédentes, dans lequel l'ouverture angulaire (α) des pixels (p) est identique dans au moins deux directions.

8. Module lumineux (M) selon l'une quelconque des revendications précédentes, dans lequel les zones lumineuses activables sélectivement (1, 2, 3, 4) sont séparées par des murets opaques ou réfléchissants ou diffusants.

9. Module lumineux (M) selon l'une des revendications précédentes, dans lequel la source lumineuse (S) comprend un moyen de connexion (20) destiné à être connecté directement ou indirectement à une alimentation électrique, ce moyen de connexion étant agencé pour alimenter électriquement et indépendamment les différentes zones lumineuses activables sélectivement (1, 2, 3, 4).

10. Module lumineux (M) selon la revendication 9, dans lequel la source lumineuse (S) est montée sur une carte électronique comprenant un dispositif de pilotage apte à alimenter sélectivement les zones lumineuses activables sélectivement (1, 2, 3, 4) en fonction d'un signal donné.

11. Module lumineux (M) selon la revendication 10, dans lequel la source lumineuse (S) est montée directement ou indirectement sur une première face de la carte électronique et le dispositif de pilotage (29) est monté directement ou indirectement sur une deuxième face de la carte électronique.

12. Module lumineux (M) l'une des revendications précédentes, dans lequel l'image (I) de la source lumineuse (S) forme au moins une partie d'un faisceau d'éclairage (F) comprenant une ligne de coupure (41).

13. Module lumineux (M) selon la revendication 12, dans lequel la zone centrale (Zc) comprend ladite ligne de coupure (41) .

14. Module lumineux (M) selon la revendication 12 ou 13, dans lequel le faisceau lumineux (F) et/ou la ligne de coupure (41) sont aptes à être déplacés par activation et/ou désactivation de certaines zones lumineuses activables sélectivement (1, 2, 3, 4).

15. Module lumineux (M) l'une des revendications précédentes, dans lequel les unités électroluminescentes de dimensions submillimétriques sont des bâtonnets électroluminescents (11, 12, 13, 14) de dimensions submillimétriques.

16. Dispositif lumineux de véhicule (D) comprenant au moins un module lumineux (M) selon l'une des revendications précédentes.

## Patentansprüche

1. Leuchtmodul (M), insbesondere für ein Fahrzeug, wobei das Leuchtmodul umfasst:
- eine Halbleiter-Lichtquelle (S), die eine Mehrzahl von elektrolumineszenten Einheiten (11, 12, 13, 14) mit submillimetrischen Abmessungen umfasst, wobei die Einheiten auf verschiedene selektiv aktivierbare Leuchtbereiche (1, 2, 3, 4) verteilt sind,
- mindestens eine Formgebungsoptik (O), die geeignet ist, die von den Leuchtbereichen (1, 2, 3, 4) emittierten Lichtstrahlen zu empfangen und sie aus dem Leuchtmodul heraus umzulenken, wobei die Formgebungsoptik so gestaltet ist, dass ein Bild (I) der Lichtquelle gebildet wird, das eine Mehrzahl von Pixeln (p) umfasst, wobei jedes Pixel (p) ein Bild eines der selektiv aktivierbaren Leuchtbereiche (1, 2, 3, 4) ist,
**dadurch gekennzeichnet, dass**:
- die Lichtquelle (S) so ausgestaltet ist und die Formgebungsoptik (O) so gestaltet ist, dass mindestens ein Teil dieser Pixel (p) eine Winkelöffnung (α) von höchstens 1° in mindestens einer gegebenen Richtung aufweist und
- die selektiv aktivierbaren Leuchtbereiche (1, 2, 3, 4) so gestaltet sind, dass das Bild (I) der Lichtquelle (S) einen mittleren Bereich (Zc) und einen außermittigen Bereich (Zp) zwischen dem mittleren Bereich und Rändern des Bildes der Lichtquelle umfasst, wobei die Mehrzahl von Pixeln (p) in dem mittleren Bereich (Zc) und in dem außermittigen Bereich verteilt sind, wobei die Pixel innerhalb des mittleren Bereichs kleiner sind als diejenigen, die sich außerhalb des mittleren Bereichs befinden.

2. Leuchtmodul (M) nach Anspruch 1, bei dem die selektiv aktivierbaren Leuchtbereiche (1, 2, 3, 4) eine Größe kleiner oder gleich 350 Mikrometer haben.

3. Leuchtmodul (M) nach Anspruch 2, bei dem die selektiv aktivierbaren Leuchtbereiche (1, 2, 3, 4) eine Größe kleiner oder gleich 100 Mikrometer haben.

4. Leuchtmodul (M) nach einem der vorhergehenden Ansprüche, bei dem die selektiv aktivierbaren Leuchtbereiche (1, 2, 3, 4), die geeignet sind, zur Bildung des mittleren Bereichs (Zc) beizutragen, so gestaltet sind, dass die vertikale Amplitude (Av), innerhalb welcher der mittlere Bereich gebildet werden kann, mindestens 6° beträgt.

5. Leuchtmodul (M) nach einem der vorhergehenden Ansprüche, bei dem die selektiv aktivierbaren Leuchtbereiche (1, 2, 3, 4), die geeignet sind, zur Bildung des mittleren Bereichs (Zc) beizutragen, so gestaltet sind, dass die horizontale Amplitude (Ah), innerhalb welcher der mittlere Bereich gebildet werden kann, mindestens etwa 10°, mindestens 20°, mindestens 40° oder mindestens 90° beträgt.

6. Leuchtmodul (M) nach einem der vorhergehenden Ansprüche, bei dem mindestens einige Pixel (p) eine Winkelöffnung (α) von höchstens 0,1° in mindestens einer gegebenen Richtung aufweisen.

7. Leuchtmodul (M) nach einem der vorhergehenden Ansprüche, bei dem die Winkelöffnung (α) der Pixel (p) in mindestens zwei Richtungen identisch ist.

8. Leuchtmodul (M) nach einem der vorhergehenden Ansprüche, bei dem die selektiv aktivierbaren Leuchtbereiche (1, 2, 3, 4) durch undurchsichtige oder reflektierende oder streuende Wände getrennt sind.

9. Leuchtmodul (M) nach einem der vorhergehenden Ansprüche, bei dem die Lichtquelle (S) ein Anschlussmittel (20) umfasst, das dazu bestimmt ist, direkt oder indirekt an eine Stromversorgung angeschlossen zu werden, wobei dieses Anschlussmittel dazu gestaltet ist, die verschiedenen selektiv aktivierbaren Leuchtbereiche (1, 2, 3, 4) elektrisch und unabhängig zu versorgen.

10. Leuchtmodul (M) nach Anspruch 9, bei dem die Lichtquelle (S) auf einer Leiterplatte montiert ist, die eine Ansteuerungsvorrichtung umfasst, die geeignet ist, die selektiv aktivierbaren Leuchtbereiche (1, 2, 3, 4) in Abhängigkeit von einem gegebenen Signal selektiv zu versorgen.

11. Leuchtmodul (M) nach Anspruch 10, bei dem die Lichtquelle (S) direkt oder indirekt auf einer ersten Seite der Leiterplatte montiert ist und die Ansteuerungsvorrichtung (29) direkt oder indirekt auf einer zweiten Seite der Leiterplatte montiert ist.

12. Leuchtmodul (M) nach einem der vorhergehenden Ansprüche, bei dem das Bild (I) der Lichtquelle (S) mindestens einen Teil eines Beleuchtungsbündels (F) bildet, das eine Hell-Dunkel-Grenze (41) umfasst.

13. Leuchtmodul (M) nach Anspruch 12, bei dem der mittlere Bereich (Zc) die Hell-Dunkel-Grenze (41) umfasst.

14. Leuchtmodul (M) nach Anspruch 12 oder 13, bei dem das Lichtbündel (F) und/oder die Hell-Dunkel-Grenze (41) geeignet sind, durch Aktivieren und/oder Deaktivieren von bestimmten selektiv aktivierbaren Leuchtbereichen (1, 2, 3, 4) verlagert zu werden.

15. Leuchtmodul (M) nach einem der vorhergehenden Ansprüche, bei dem die elektrolumineszenten Einheiten mit submillimetrischen Abmessungen elektrolumineszente Stäbchen (11, 12, 13, 14) mit submillimetrischen Abmessungen sind.

16. Fahrzeugleuchtvorrichtung (D), die mindestens ein Leuchtmodul (M) nach einem der vorhergehenden Ansprüche umfasst.

## Claims

1. Light module (M), notably of a vehicle, said light module comprising:
- a semiconductor light source (S) comprising a plurality of light-emitting units (11, 12, 13, 14) of submillimetric dimensions, the units being distributed in different selectively activatable light zones (1, 2, 3, 4),
- at least one shaping optic (O), capable of receiving the light rays emitted by said light zones (1, 2, 3, 4) and of deflecting them out of the light module, the shaping optic being arranged in such a way as to form an image (I) of the light source comprising a plurality of pixels (p), each pixels (p) is an image of one of said selectively activatable light zones (1, 2, 3, 4)
charactherized in that
- the light source (S) is configured and the shaping optic (O) is arranged in such a way that at least a part of these pixels (p) exhibit an angular aperture (α) of at most 1° in at least one given direction; and
- the selectively activatable light zones (1, 2, 3, 4) are arranged in such a way that the image (I) of the light source (S) comprises a central zone (Zc) and an off-center zone (Zp) between said central zone and edges of the image of the light source, the plurality of pixels (p) being distributed in the central zone (Zc) and in the off-center zone, the pixels inside the central zone being smaller than those situated outside of the central zone.

2. Light module (M) according to Claim 1, in which the selectively activatable light zones (1, 2, 3, 4) have a size less than or equal to 350 micrometers.

3. Light module (M) according to Claim 2, in which the zones the selectively activatable light zones (1, 2, 3, 4) have a size less than or equal to 100 micrometers.

4. Light module (M) according to one of the preceding claims, in which the selectively activatable light zones (1, 2, 3, 4) capable of participating in the forming of said central zone (Zc) are arranged in such a way that the vertical amplitude (Av) within which said central zone can be formed is at least 6°.

5. Light module (M) according to any one of the preceding Claims, in which the selectively activatable light zones (1, 2, 3, 4) capable of participating in the forming of said central zone (Zc) are arranged in such a way that the horizontal amplitude (Ah) within which said central zone can be formed is at least approximately 10°, at least 20°, at least 40° or at least 90°.

6. Light module (M) according to any one of the preceding claims, in which at least some pixels (p) exhibit an angular aperture (α) of at most 0.1° in at least one given direction.

7. Light module (M) according to any one of the preceding claims, in which the angular aperture (α) of the pixels (p) is identical in at least two directions.

8. Light module (M) according to any one of the preceding claims, in which the selectively activatable light zones (1, 2, 3, 4) are separated by opaque or reflecting or diffusing kerbs.

9. Light module (M) according to one of the preceding claims, in which the light source (S) comprises a connection means (20) intended to be connected directly or indirectly to an electrical power supply, this connection means being arranged to electrically and independently power the different selectively activatable light zones (1, 2, 3, 4).

10. Light module (M) according to Claim 9, in which the light source (S) is mounted on an electronic card comprising a driving device capable of selectively powering the selectively activatable light zones (1, 2, 3, 4) based on a given signal.

11. Light module (M) according to Claim 10, in which the light source (S) is mounted directly or indirectly on a first face of the electronic card and the driving device (29) is mounted directly or indirectly on a second face of the electronic card.

12. Light module (M) one of the preceding claims, in which the image (I) of the light source (S) forms at least a part of a lighting beam (F) comprising a cut-off line (41).

13. Light module (M) according to Claim 12, in which the central zone (Zc) comprises said cut-off line (41).

14. Light module (M) according to Claim 12, in which the light beam (F) and/or the cut-off line (41) are capable of being displaced by activation and/or deactivation of certain selectively activatable light zones (1, 2, 3, 4).

15. Light module (M) one of the preceding claims, in which the light-emitting units of submillimetric dimensions are light-emitting rods (11, 12, 13, 14) of submillimetric dimensions.

16. Vehicle light device (D) comprising at least one light module (M) according to one of the preceding claims.
